# EUROPÄISCHE PATENTSCHRIFT

(11) **EP 2 812 973 B1**
(45) Veröffentlichungstag und Bekanntmachung des Hinweises auf die Patenterteilung: **11.04.2018**
(21) Anmeldenummer: 13703523.4
(22) Anmeldetag: 28.01.2013
(51) Int. Cl.: H02J 3/32, H02J 3/38

(54) **ENERGIEGEWINNUNGSSYSTEM MIT ENERGIESPEICHER, VERFAHREN ZUM BETREIBEN EINES ENERGIEGEWINNUNGSSYSTEMS**
ENERGY HARVESTING SYSTEM WITH ENERGY ACCUMULATOR AND METHOD FOR OPERATING AN ENERGY HARVESTING SYSTEM
SYSTÈME DE PRODUCTION D'ÉNERGIE DOTÉ D'UN ACCUMULATEUR D'ÉNERGIE ET PROCÉDÉ DE FONCTIONNEMENT D'UN SYSTÈME DE PRODUCTION D'ÉNERGIE

(30) Priorität: 07.02.2012 DE 102012002185
(43) Veröffentlichungstag der Anmeldung: 17.12.2014
(73) Patentinhaber: Sew-Eurodrive GmbH & Co. KG, 76646 Bruchsal (DE)
(72) Erfinder: SCHIFFMANN, Sebastian, 76709 Kronau (DE); SCHMIDT, Josef, 76676 Graben-Neudorf (DE); HAUCK, Matthias, 68723 Schwetzingen (DE); LAMPERT, Christian, 76646 Bruchsal (DE); TRITSCHLER, Daniel, 76646 Bruchsal (DE); ZÖLLER, Thomas, 76646 Bruchsal (DE)
(86) Internationale Anmeldenummer: PCT/EP2013/000238
(87) Internationale Veröffentlichungsnummer: WO 2013/117305

(56) Entgegenhaltungen:
- EP-A2- 2 339 714
- DE-A1-102010 016 138
- US-A1- 2011 210 614
- VELASCO D ET AL: "Photovoltaic power management system with grid connected and islanded operation", INDUSTRIAL ELECTRONICS (ISIE), 2011 IEEE INTERNATIONAL SYMPOSIUM ON, IEEE, 27 June 2011 (2011-06-27), pages 1471-1476, XP032019270, DOI: 10.1109/ISIE.2011.5984377 ISBN: 978-1-4244-9310-4

## Beschreibung

Die Erfindung betrifft ein Energiegewinnungssystem mit Energiespeicher und ein Verfahren zum Betreiben eines Energiegewinnungssystems.

Es ist allgemein bekannt, dass beleuchtete Solarzellen elektrische Energie in Form von Gleichstrom erzeugen, die einem Wechselrichter an dessen gleichstromseitigem Anschluss zuführbar ist.

**Aus der** EP2 339 714A2 **ist ein Verfahren zum Steuern eines Energiespeichersystems bekannt, bei dem die von einem Solargenerator erzeugte Energie einem MPPT Converter zugeführt wird, der an seinem anderen Anschluss mit einem Stromrichter 113 verbunden ist.**

**Aus der** DE10 2010 016138A1 **ist als nächstliegender Stand der Technik ein Verfahren nach dem Oberbegriff des Anspruchs 1 bekannt, wobei Energie aus einem Stromspeicher der Gleichspannungsseite des Wechselrichters zugeführt wird.**

**Aus der** EP2 339 714A2 **ist ein Steuerverfahren für ein Energiespeichersystem bekannt, wobei einem Generator ein Stromrichter parallel geschaltet ist, insbesondere mit dessen erstem gleichstromseitigen Anschluss, wobei der Stromrichter mit einem Energiespeicher verbunden ist, der mit dem zweiten gleichstromseitigen Anschluss des Stromrichters verbunden ist.**

**Aus der Veröffentlichung** Velasco, D. & al., Photovoltaic Power Management System with Grid Connected and Islanded Operation, IEEE Gdansk, 27-30 June 2011, XP032019270**, ist ein Energiemanagementsystem für Solaranlagen bekannt.**

**Aus der Veröffentlichung** Velasco, D & al., Photovoltaic Power Management System with Grid Connected and Islanded Operation, IEEE international Symposium on Industrial Electronics, Gdansk, 27-30 June 2011 (30-6-2011) XP032019270 **ist als nächstliegender Stand der Technik ein Leistungsmanagementsystem für eine Photovoltaik-anlage bekannt.**

Der Erfindung liegt daher die Aufgabe zugrunde, ein Energiegewinnungssystem weiterzubilden. Erfindungsgemäß wird die Aufgabe bei dem Verfahren nach Anspruch 1 angegebenen Merkmalen gelöst.

Wichtige Merkmale der Erfindung bei dem Energiegewinnungssystem mit Energiespeicher sind, dass ein Solargenerator, insbesondere ein Solarzellen umfassendes Modul, mit einem Wechselrichter verbunden ist, insbesondere an dessen gleichstromseitigem Anschluss,
wobei der Wechselrichter an seinem wechselspannungsseitigen Anschluss mit einem Verbraucher und/oder einem Wechselstromnetz verbunden ist,
**wobei** dem Solargenerator, insbesondere dem oder den Solarzellen umfassenden Modulen, ein DC/DC-Wandler parallel geschaltet ist, insbesondere mit dessen erstem gleichstromseitigen Anschluss,
wobei der DC/DC-Wandler mit einem Energiespeicher verbunden ist, insbesondere der mit dem zweiten gleichstromseitigen Anschluss des DC/DC-Wandlers verbunden ist.

Statt DC/DC-Wandler ist auch ein anderer Stromrichter verwendbar.

Von Vorteil ist dabei, dass der Wechselrichter, insbesondere der MPP-Tracker des Wechselrichters, trotz zusätzlich verbundenem Energiespeicher ungestört weiterarbeitet. Denn die Arbeitskennlinien des DC/DC-Wandlers sind derart wählbar, dass zwar der Energiefluss in oder aus dem Energiespeicher steuerbar ist. Trotzdem ist aber das Auffinden des Leistungs-Maximums der von dem Solargenerator erzeugten elektrischen Energie in gleicher Weise vom MPP-Tracker, also Maximum Power Point Tracker, auffindbar.

**Somit sind vorhandene Solaranlagen, welche einen Solargenerator und einen Wechselrichter zur Netzeinspeisung der erzeugten Energie aufweisen, mit einem Energiespeicher nachrüstbar,** indem der DC/DC-Wandler parallel zu dem Solargenerator zugeschaltet wird. Somit ist dann nach Bedarf Energie von dem Solargenerator über den DC/DC-Wandler in den Energiespeicher einspeisbar. Entsprechend ist Energie aus dem Energiespeicher dem Wechselrichter zuführbar, wenn entsprechender Bedarf vorliegt - beispielsweise bei Nacht oder bei zu geringer Beleuchtungsstärke des Solargenerators.

**Weiterer Vorteil ist also auch, dass bestehende Photovoltaikanlagen nachrüstbar sind ohne gerätespezifisches Wissen über den jeweiligen Photovoltaikwechselrichter und ohne Implementierung einer Kommunikation bzw. eines Datenaustausches zur bestehenden Anlage.**

Bei einer vorteilhaften Ausgestaltung ist dem Solargenerator, insbesondere dem Solarzellen umfassenden Modul, ein Folienkondensator parallel geschaltet. Von Vorteil ist dabei, dass hochfrequente Spannungsschwankungen abpufferbar sind.

Bei einer vorteilhaften Ausgestaltung weist der Energiespeicher einen Doppelschichtkondensator auf und/oder besteht aus mehreren miteinander verschalteten Doppelschichtkondensatoren und/oder der Energiespeicher weist einen Akkumulator und/oder eine Batterie auf. Von Vorteil ist dabei, dass sehr hohe Kapazitäten in kostengünstiger Weise bei geringer Masse des Energiespeichers bereit stellbar sind. Weiter weist der Wechselrichter einen MPP-Tracker auf. Von Vorteil ist dabei, dass der MPP-Tracker den Arbeitspunkt maximaler Leistung des Solargenerators ansteuert. Somit ist auch bei schwankenden Betriebsbedingungen, wie Temperaturschwankungen und/oder Beleuchtungsstärke-Schwankungen, die maximale Leistungsausbeute bei dem Solargenerator erreichbar. Hierzu regelt der Wechselrichter auf die zu diesem Arbeitspunkt zugehörige Spannung hin, indem er kleine Spannungsänderungen einsteuert und die sich daraufhin einstellende Leistung bestimmt. Schrittweise wird dann die Spannung in diejenige Richtung verändert, in welcher die Leistung anwächst.

Wichtige Merkmale bei dem Verfahren zum Betreiben eines Energiegewinnungssystems, nach Anspruch 1 sind, dass ein Solargenerator, insbesondere ein oder mehrere Solarzellen umfassende Module, mit einem Wechselrichter verbunden ist, insbesondere an dessen gleichstromseitigem Anschluss,
wobei der Wechselrichter an seinem wechselspannungsseitigen Anschluss mit einem Verbraucher und/oder einem Wechselstromnetz verbunden ist,
insbesondere wobei der Wechselrichter einen MPP-Tracker aufweist,
**wobei** aus einem Energiespeicher über einen DC/DC-Wandler elektrische Energie dem Wechselrichter zugeführt wird,
wobei am Wechselrichter gleichstromseitig anliegende Spannung erfasst wird und eine vom DC/DC-Wandler an den gleichstromseitigen Anschluss des Wechselrichters zu liefernde Soll-Leistung gemäß einer Kennlinie bestimmt wird,
Von Vorteil ist dabei, dass die Kennlinie derart wählbar ist, dass das Auffinden des Arbeitspunktes mit der maximalen von dem Solargenerator erzeugten Leistung unverändert ermöglicht ist. Weiter wird die vom DC/DC-Wandler an den gleichstromseitigen Anschluss des Wechselrichters gelieferte Soll-Leistung bestimmt, insbesondere indem die gleichstromseitig anliegende Spannung mit dem vom DC/DC-Wandler an den Wechselrichter gelieferten Strom multipliziert wird, und aus der Differenz zwischen Soll-Leistung und Ist-Leistung der vom DC/DC-Wandler an den Wechselrichter zu liefernde Strom bestimmt wird, insbesondere wobei weitere Einflussgrößen, wie Betriebsart, Verhalten des MPP-Trackers des Wechselrichters oder dergleichen, berücksichtigt werden. Von Vorteil ist dabei, dass über die Vorgabe der Kennlinie des DC/DC-Wandlers die vom Energiespeicher zum gleichstromseitigen Anschluss des Wechselrichters zugeführte oder von dort abgeführte elektrische Leistungsmenge steuerbar ist. Weiter stellt die Kennlinie einen derartigen Zusammenhang zwischen Leistung und gleichstromseitiger Spannung dar, dass nach Addition der entsprechenden Leistungs-Spannungs-Kennlinie des Solargenerators derjenige Wert der Spannung, bei dem ein Maximum an Leistung vorliegt, im Wesentlichen unverändert bleibt. Von Vorteil ist dabei, dass der die Arbeitsweise des MPP-Trackers im Wesentlichen ungestört verläuft, obwohl zusätzlich der DC/DC-Wandler parallel zu dem Solargenerators zugeschaltet ist. Weiter ist die Kennlinie derart wenig veränderlich, dass nach Addition der entsprechenden Leistungs-Spannungs-Kennlinie des Solargenerators derjenige Wert der Spannung, bei dem ein Maximum an Leistung vorliegt, im Wesentlichen unverändert bleibt, insbesondere so dass der MPP-Tracker auf dasselbe Leistungsmaximum des Solargenerators hinregelt, wie wenn kein Energiespeicher mit DC/DC-Wandler vorhanden wäre. Von Vorteil ist dabei, dass wiederum der die Arbeitsweise des MPP-Trackers im Wesentlichen ungestört verläuft, obwohl zusätzlich der DC/DC-Wandler parallel zu dem Solargenerator zugeschaltet ist.

Wichtige Merkmale bei dem Verfahren zum Betreiben eines Energieerzeugungssystems nach Anspruch 1 sind, dass ein Wechselrichter mit MPP-Tracker den gleichstromseitigen Eingangsstrom erfasst und die Spannung an seinem gleichstromseitigen Anschlussklemmen auf ein Maximum an Leistung hin regelt,
wobei Energieerzeugungsmittel, insbesondere Solargenerator, an seinem gleichstromseitigen Anschluss angeschlossen sind,
**wobei** eine Vorrichtung an dem gleichstromseitigen Anschluss angeschlossen wird, welche aus der gleichstromseitig erfassten Spannung unter Berücksichtigung einer Kennlinie eine Soll-Leistung bestimmt und den von der Vorrichtung an den gleichstromseitigen Anschluss des Wechselrichters gelieferten Ist-Strom sowie die gleichstromseitig am Wechselrichter anliegende Spannung erfasst und daraus eine Ist-Leistung bestimmt, die die Vorrichtung auf die Soll-Leistung hinregelt, indem sie einen entsprechenden Soll-Strom bestimmt und darauf hinregelt,
insbesondere wobei die Kennlinie die Abhängigkeit der Soll-Leistung von der gleichstromseitig am Wechselrichter anliegenden Spannung darstellt,
insbesondere wobei die Kennlinie mittels eines primären Stelleingriffs veränderbar ist.

Von Vorteil ist dabei, dass der DC/DC-Wandler einen Stromregler aufweist, dem ein Leistungsregler beziehungsweise ein Leistungsbestimmungsmittel übergeordnet ist, wobei eine Kennlinie verwendet wird, mittels welcher das Leistungsmanagement des Energiespeichers ausführbar ist. Dabei ist dieses Leistungsmanagement unabhängig von der Arbeitsweise des Wechselrichters samt MPP Tracker ausführbar. Weiter wird die Kennlinie entsprechend von Einflussgrößen verändert wird, insbesondere gedehnt oder gestaucht. Von Vorteil ist dabei, dass die Ordinatenwerte mit einem Faktor abhängig von den Einflussgrößen multipliziert werden. Somit ist durch einfache Rechenoperationen ein Anpassen an Einflussgrößen ausführbar.

Bei einer vorteilhaften Ausgestaltung weist das Vorzeichen der Kennlinie abhängig von der Betriebsart, insbesondere Entnahme von Energie aus dem oder Zuführung von Energie in den Energiespeicher. Von Vorteil ist dabei, dass mittels des Vorzeichens die Entnahme oder Zuführung, also die Energieflussrichtung steuerbar ist.

Bei einer vorteilhaften Ausgestaltung weist die Kennlinie einen im Wesentlichen konstanten Soll-Leistungs-Wert auf in einem Spannungs-Bereich, welcher denjenigen jeweiligen Spannungswert umfasst, welcher dem Leistungsmaximum des Solargenerators zugeordnet ist, insbesondere welcher dem Leistungsmaximum des Solargenerators zugeordnet ist bei allen Beleuchtungsstärken des Solargenerators. Von Vorteil ist dabei, dass eine flache Kennlinie in diesem Spannungsberiech bewirkt, dass der MPP-Tracker ungestört arbeitet.

Bei einer vorteilhaften Ausgestaltung weist die Kennlinie einen lokal minimalen Verlauf der Soll-Leistungs-Werte in Abhängigkeit von der Spannung auf in einem Spannungs-Bereich, welcher denjenigen jeweiligen Spannungswert umfasst, welcher dem Leistungsmaximum des Solargenerators zugeordnet ist, insbesondere welcher dem Leistungsmaximum des Solargenerators zugeordnet ist bei allen Betriebsbedingungen, wie zulässigen Temperaturen und Beleuchtungsstärken, des Solargenerators. Von Vorteil ist dabei, dass mittels des lokalen Minimums der Leistungsfluss aus oder in den Energiespeicher entsprechend spannungsabhängig anpassbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist ein schematischer Aufbau eines erfindungsgemäßen dezentralen Energiegewinnungssystems mit Energiespeicher 4 gezeigt.
In der Figur 2 ist die Berücksichtigung der übergeordneten Einflussgrößen auf die Arbeitsweise des Energiespeichers 4 gezeigt.
In der Figur 3 ist die Erzeugung einer Arbeitskennlinie des Systems für den Zustand der Energieabgabe aus dem Speicher 4, insbesondere bei Tageslicht, gezeigt.
In der Figur 4 ist die Erzeugung einer Arbeitskennlinie des Systems für den Zustand der Energieaufnahme in den Speicher 4, insbesondere bei Tageslicht, gezeigt.
In der Figur 5 ist die Erzeugung einer Arbeitskennlinie des Systems für den Zustand der Energieabgabe aus dem Speicher 4, insbesondere bei Nacht, gezeigt.
In der Figur 6 ist ein erster Teil und in der Figur 7 ein weiterer Ausschnitt eines Kennlinienblocks gezeigt.

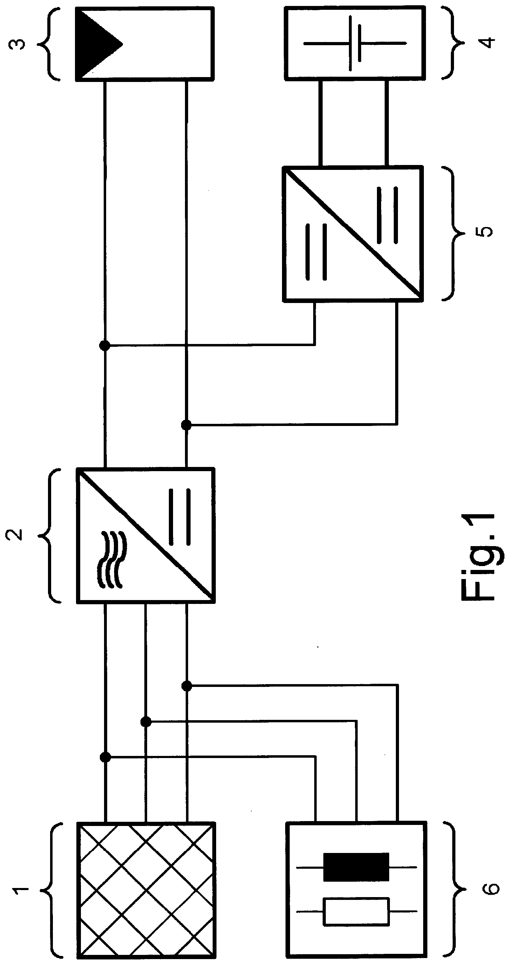

Wie in Figur 1 gezeigt, weist das System einen Solargenerator 3 auf, der bei Bestrahlung mit Licht elektrische Energie bereit stellt, insbesondere in Form einer unipolaren Spannung, insbesondere Gleichspannung. Der Solargenerator 3 ist an einen Wechselrichter 2 angeschlossen, dessen insbesondere ein- oder mehrphasiger Wechselstromausgang mit dem entsprechenden Netz 1 verbunden ist.

Parallel zu dem Solargenerator 3 ist ein DC/DC-Wandler 5 zugeschaltet, so dass Energie aus einem Energiespeicher 4 dem Wechselrichter 2 zuführbar ist.

Netzseitig sind auch Verbraucher als Last 6 am Wechselstromausgang des Wechselrichters 2 angeordnet.

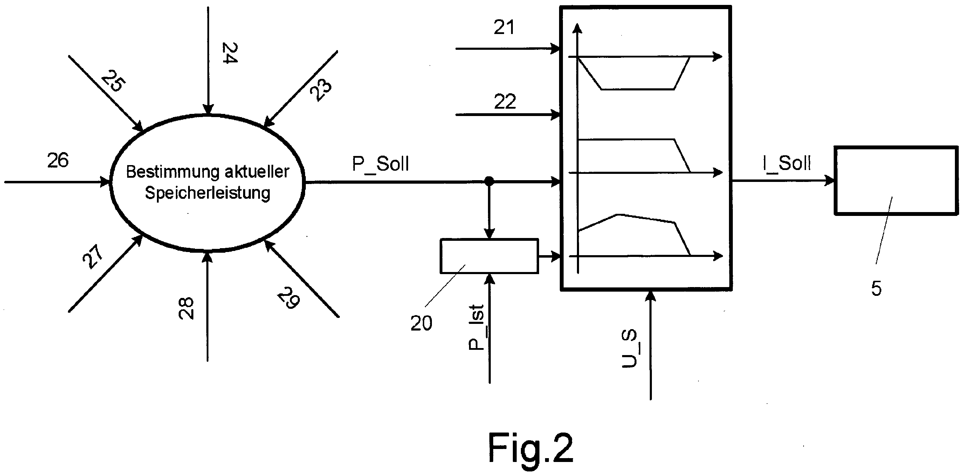

Wie in Figur 2 dargestellt, wird aus Einflussgrößen, wie Marktpreis 23, Lastprognose 24, Speicherstand 25, zur Verfügung stellbare, im Energiespeicher 4 gespeicherte Energiemenge, lokaler Verbrauch 26, Solarleistung 27, Anforderungen 28 des Netzbetreibers oder einer übergeordneten Steuerung und/oder Wetterprognose 29, eine Soll-Leistung P_Soll bestimmt.

Der ausgangsseitige Strom I_Ist des DC/DC-Wandlers 5 und die ausgangsseitige Spannung U_ist = U_S wird erfasst und daraus die Ist-Leistung P_Ist bestimmt.

Aus der in einer Nachführung 20 bestimmten Differenz zwischen der Ist-Leistung P_Ist und der Soll-Leistung P_Soll wird ein Wert bestimmt, der ebenso wie die Soll-Leistung P_Soll einem Bestimmungsblock zugeführt wird, der unter Berücksichtigung des Verhaltens 21 des MPP-Trackers und der Betriebsart 22 sowie der Spannung U_S einen Strom-Sollwert I_Soll bestimmt, auf den der vom DC/DC-Wandler 5 an den parallel geschalteten Wechselrichter 2 gespeiste Strom hin geregelt wird.

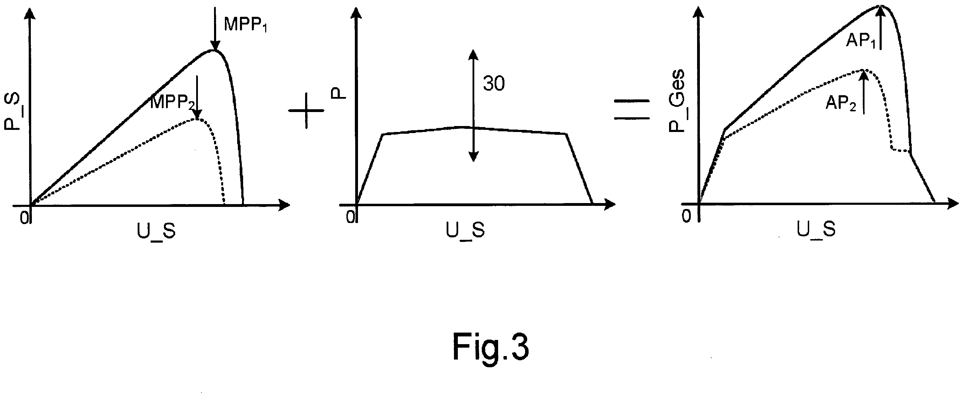

Auf diese Weise wird, wie in Figur 3 gezeigt, ermöglicht, dass der MPP-Tracker ungestört durch den zusätzlich zu dem Solargenerator 3 verbundenen DC/DC-Wandler 5 den Punkt maximaler Leistung findet. Dabei verändert der MPP-Tracker die jeweils an dem Solargenerator 3 anliegende Spannung U_S um einen kleinen Betrag und bestimmt aus dem daraus resultierenden erfassten Strom die momentane Leistung. Auf diese Weise wird die Spannung derart verändert, dass stets der Arbeitspunkt im Wesentlichen maximaler Leistung für den Solargenerator 3 eingestellt wird.

Hierzu ist in dem linken Schaubild der Figur 3 die Leistung des Solargenerators als Funktion der an dem Solargenerator 3 anliegenden Spannung U_S gezeigt. Bei veränderten Betriebsbedingungen, insbesondere geringerer Beleuchtungsstärke, gilt die punktierte Kennlinie statt der durchgezogene Kennlinie. In jedem Fall wird mit dem beschriebenen Suchverfahren des MPP-Trackers das Optimum der Leistung gefunden oder zumindest der Betriebspunkt auf dieses Optimum hin geregelt.

Wie im mittleren Schaubild der Figur 3 gezeigt, wird die von dem DC/DC-Wandler 5 zur Verfügung zu stellende Leistung gemäß einer Kennlinie bestimmt in Abhängigkeit von der Spannung U_S. Mit Bezugszeichen 30 ist hierbei der primäre Stelleingriff auf diese Kennlinie dargestellt. Denn die Kennlinie wird verändert, insbesondere gedehnt in Ordinatenrichtung, gemäß dem Vorgehen nach Figur 2.

Grundsätzlich ähneln sich dabei die Kennlinien, indem sie alle bei von 0 ansteigender Spannung U_S zunächst steil ansteigen auf einen fast konstanten Bereich, von dem aus sie bei hoher Spannung U_S wieder steil abfallen. Dabei hat der fast konstante Bereich ein lokales Maximum, welches so festgelegt ist, dass die dazugehörende Spannung kleiner gleich allen möglichen MPP-Spannungen des Solargenerators ist. Wichtig ist dabei, dass die Änderungen im fast konstanten Bereich geringer sind als die Änderungen in der Kennlinie der Solarzelle im gleichen Spannungsbereich, jedoch groß genug um vom MPP-Tracker erfasst zu werden, falls keine solare Leistung zur Verfügung steht. Somit bleibt bei der addierten Kennlinie das Maximum im Wesentlichen bei denselben Spannungswerten.

Darüber hinaus wird durch diese Verfahren sichergestellt, dass im Falle eines plötzlichen starken Abfalls der MPP-Spannung des Solargenerators, z.B. aufgrund einer Wolkenabschattung, der neue MPP des Solargenerators immer sicher erkannt wird.

Vorteil ist also, dass bei gleichzeitiger Einspeisung, also Leistungszufuhr an den Wechselrichter, aus Solargenerator und Speicher, wie in Figur 3 dargestellt, sichergestellt ist, dass der MPP-Tracker nach einer Abschattung wieder auf einen Arbeitspunkt maximaler Leistung (MPP) unterhalb der aktuellen Solarspannung hinsteuert.

Somit wird also je nach den Einflussgrößen eine entsprechende Kennlinie bestimmt und diese wiederum verwendet zur Bestimmung der momentanen zur Verfügung zu stellenden Soll-Leistung P.

Wie in Figur 3 gezeigt, führt die Summe aus den beiden genannten Kennlinien zu einer Kennlinie, deren Maximum an im Wesentlichen derselben Stelle angeordnet ist. Daher bleibt die Arbeitsweise des MPP-Trackers ungestört. Denn dieser findet weiterhin durch Variieren der Spannung den Arbeitspunkt mit der vom Solargenerator erzeugten größeren Leistung.

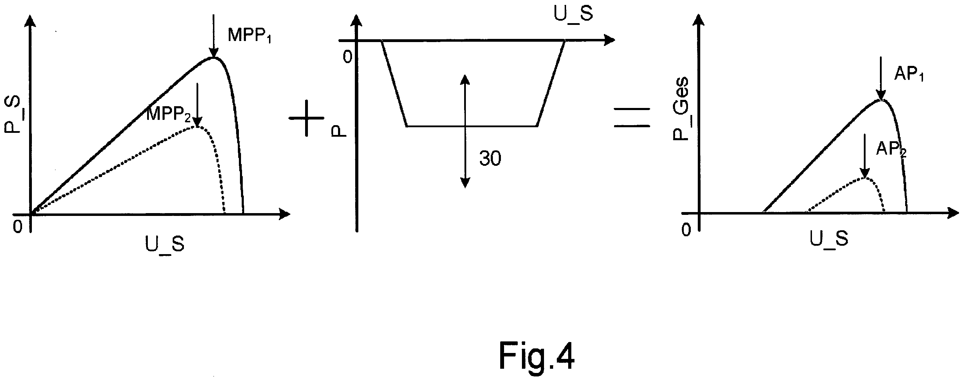

In Figur 4 sind für die Energieaufnahme in den Energiespeicher 4 bei Tag, also bei elektrische Leistung erzeugendem Solargenerator 3, die entsprechenden Kennlinien gezeigt. Auch hier bleibt die Arbeitsweise des MPP-Trackers ungestört.

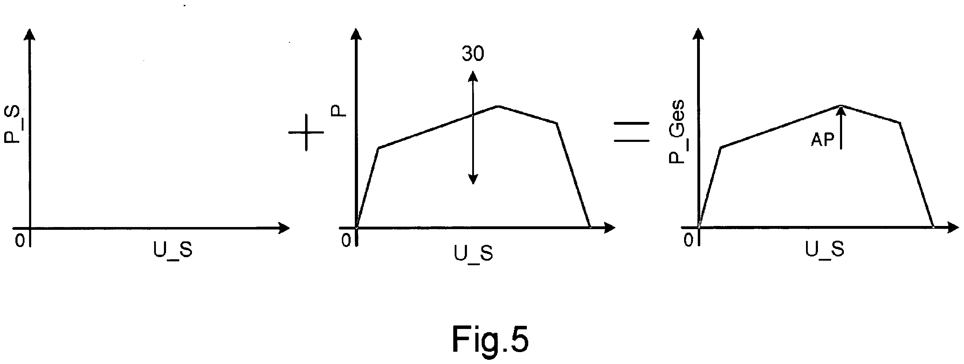

In Figur 5 ist der Zustand bei nicht beleuchtetem Solargenerator 3 gezeigt, wobei diese dann keine elektrische Leistung erzeugen. Die entsprechend vorgegebene Kennlinie weist ein Maximum auf, auf welches der MPP-Tracker hinsteuert und somit auf den hierzu vorgegebenen Arbeitspunkt. Vorzugsweise ist das Maximum im optimalen Arbeitspunkt des DC/DC-Wandlers und/oder des Gesamtsystems angeordnet.

Wichtig ist also bei der Erfindung, dass durch das Vorgeben einer geeigneten Kennlinie aus einer durch den Primären Stelleingriff jeweils aktivierbaren Kennlinienschar die Arbeitsweise des MPP-Trackers ungestört bleibt im Vergleich zu nicht vorhandenem Energiespeicher 4 mit DC/DC-Wandler 5.

Somit ist also ein bestehendes System ohne Energiespeicher 4 und DC/DC-Wandler 5 nachrüstbar, wobei das bisherige System ungestört weiterarbeitet. Durch Vorgabe einer Kennlinie für die Leistungsbestimmung des DC/DC-Wandlers, die die Kennlinie des Solargenerators 3 qualitativ nicht verändert, findet der MPP-Tracker weiterhin den optimalen Arbeitspunkt.

Bei beleuchtetem Solargenerator 3 und Energieabgabe aus dem Energiespeicher 4, also erster Betriebsart, oder bei unbeleuchtetem Solargenerator 3 und Energieaufnahme in den Energiespeicher 4, also dritter Betriebsart oder bei beleuchtetem Solargenerator 3 und Energieabgabe des Energiespeichers 4, also zweiter Betriebsart werden jeweils verschiedenartige Kennlinien verwendet. Abhängig von dem primären Stelleingriff 30 wird bei jeder der Betriebsarten die jeweilige Kennlinie gedehnt oder gestaucht. Jedoch gehen die bei den genannten drei Betriebsarten verwendeten Kennlinien nicht durch Dehnung oder Stauchung ineinander über. Insbesondere weist die Kennlinie der zweiten Betriebsart ein anderes Vorzeichen auf als die Kennlinie der ersten Betriebsart. Außerdem weist die Kennlinie der zweiten Betriebsart kein lokales Maximum auf sondern ein Minimum, welches als Plateau ausgeführt ist. Bei der dritten Betriebsart weist die Kennlinie ein einziges ausgeprägtes Extremum auf, so dass der MPP-Tracker diesen Betriebspunkt findet.

Der Wechselrichter weist also einen Gleichstromanschluss auf, an dem der Solargenerator 3 und der DC/DC-Wandler 5 angeschlossen sind. Außerdem weist er einen Wechselstromanschluss auf, an dem er mit dem Wechselspannungsnetz 1 und zumindest einem Verbraucher verbunden ist.

Vorzugsweise ist der Wechselrichter an seinem Wechselstromseitigen Anschluss für ein einphasiges oder ein dreiphasiges Netz ausgeführt.

Die normierte Kennlinie nach Figur 3, also Leistungsaufnahme des Speichers, hat über den gesamten Arbeitsbereich des Solargenerators einen konstanten, insbesondere negativen, Verlauf und fällt am Rand des Arbeitsbereiches auf null ab. Die vorgelagerte Steuerung zur Bestimmung von P_soll sorgt dafür, dass der Betrag des Sollwertes der Speicherleistung P_soll stets unterhalb der aktuellen Solarleistung liegt.

Die Kennlinie nach Figur 4, also zur Leistungsabgabe des Speichers bei vorhandener PV-Leistung (Tag), hat über den gesamten Arbeitsbereich des Solargenerators einen nahezu konstanten Verlauf und fällt am Rand des Arbeitsbereiches auf null ab. Im nahezu konstanten Bereich existiert ein Maximum, welches so festgelegt ist, dass die dazugehörende Spannung kleiner gleich allen möglichen MPP-Spannungen des Solargenerators ist.

Die Kennlinie nach Figur 5, also zur Leistungsabgabe des Speichers ohne vorhandene PV-Leistung (Nacht), hat ein ausgeprägtes Maximum bei der Spannung U_S, welche sich nach dem Arbeitspunkt der höchsten Effizienz des Gesamtsystems richtet.

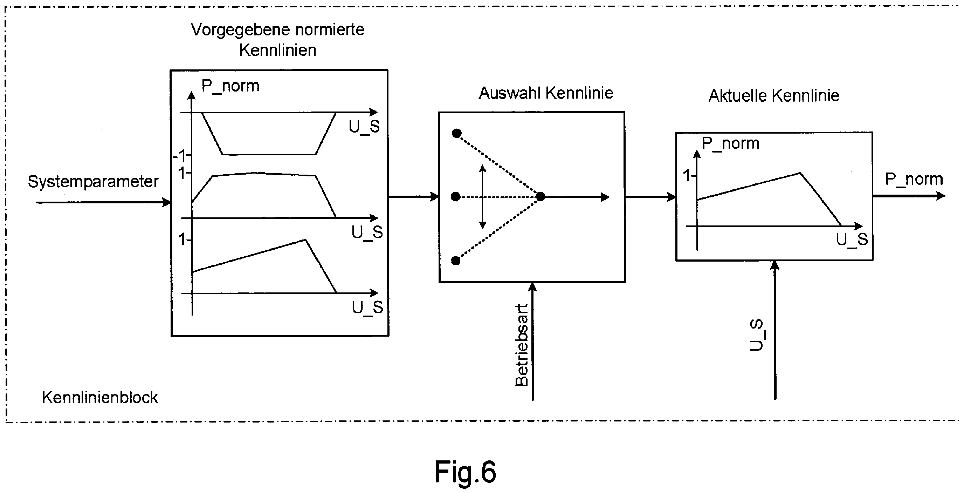

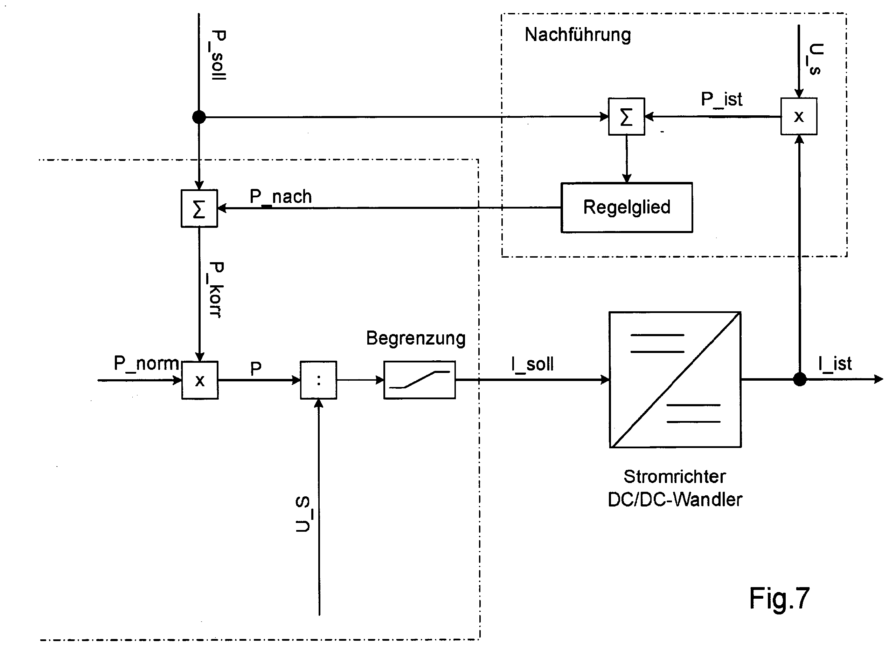

Der Verlauf der Kennlinien der Figuren 3, 4 und 5 wird unter Berücksichtigung der zeitlich nicht veränderlichen Systemparameter bestimmt, wie in Figur 6 und 7 gezeigt:
- Spannungsschrittweitenverhalten des MPPT
- Auflösung der Leistungsmessung des MPPT
- Spannungsbereich des Solargenerators
- Spannungsbereich des MPPT

Die Systemparameter werden entweder messtechnisch durch das Energiespeichersystem erfasst und/oder bei Inbetriebnahme als Parameter vorgegeben.
Wie in Figur 6 und Figur 7 gezeigt, erfolgt die Auswahl der jeweiligen Kennlinie abhängig von der Betriebsart, die sich aus dem Sollwert der Speicherleistung und dem Zustand des Solargenerators (z.B. Tag / Nacht) ergibt.

Mit der mittels eines Auswahlmittels Betriebsart-abhängig-gewählten Kennlinie und der anliegenden Solarspannung wird ein normierter Leistungssollwert P_norm ermittelt, der mit einem korrigierten Leistungssollwert P_korr multipliziert wird. Bezüglich der Kennlinie bedeutet dies ein Strecken derselben, **also den Primären Stelleingriff.** Das Ergebnis P wird durch die anliegende Solarspannung U_S dividiert und anschließend begrenzt. Das Resultat I_soll wird dem DC/DC-Wandler als Stromsollwert vorgegeben.

Die Nachführung hat die Aufgabe mögliche Abweichungen zwischen Soll und Ist-Speicherleistung auszuregeln. Dabei muss die Zeitkonstante des Regelgliedes mindestens eine Größenordnung über der des MPPT liegen, um eine gegenseitige Beeinflussung zu verhindern.

P_Korr wird also als Summe von P_Soll und dem Ausgangssignal P_nach der Nachführung bestimmt. Dieses Ausgangssignal P_nach wird als Ausgangssignal eines Regelgliedes, insbesondere PI-Regelgliedes, bestimmt dem eingangsseitig die Differenz zwischen P_Soll und der erfassten Istleistung P_Ist zugeführt wird, die durch Erfassen des Istwertes des ausgangsseitig am DC/DC-Wandler austretenden Stromes I_Ist und Multiplikation mit der Spannung U_S bestimmt wird.

P_korr wird als Streckungsfaktor für P_norm verwendet.

Durch Division des durch die Multiplikation von P_norm und P_korr bestimmten Wertes P durch U_S und nachfolgende Begrenzung des Divisionsergebnisses wird der Sollstrom I_Soll bestimmt, welcher dem DC/DC-Wandler vorgegeben wird.

Bei einem weiteren erfindungsgemäßen Ausführungsbeispiel wird als Energiespeicher ein Rotationsspeicher verwendet, wobei dann statt des DC/DC-Wandlers ein DC/AC-Wandler verwendet wird, wobei die Wechselstromanschlüsse AC mit dem Rotationsspeicher verbunden sind. Der Einfachheit halber soll deshalb in dieser Schrift unter einem Stromrichter entweder ein DC/DC-Wandler für einen Energiespeicher, wie Kondensator, Akkumulator oder Batterie, oder ein DC/AC-Wandler für einen Rotationsspeicher verstanden werden.

### Bezugszeichenliste

1 Netz
2 Wechselrichter mit MPP-Tracker
3 Solargenerator, insbesondere ein oder mehrere Solarzellen umfassende Module
4 Energiespeicher
5 DC/DC-Wandler
6 Last, Verbraucher
20 Nachführung
21 Verhalten des MPP-Trackers
22 Betriebsart
23 Marktpreis
24 Lastprognose
25 Speicherstand, zur Verfügung stellbare, im Energiespeicher 4 gespeicherte Energiemenge
26 lokaler Verbrauch
27 Solarleistung P_Soll
28 Anforderungen des Netzbetreibers oder einer übergeordneten Steuerung
29 Wetterprognose
30 primärer Stelleingriff
P_Soll Soll-Leistung
P_Ist Ist-Leistung
I_Soll Soll-Strom
I_Ist Ist-Strom
U_S Solarspannung
P Speicherleistung
P_S Solarleistung
P_Ges Gesamtleistung

## Patentansprüche

1. Verfahren zum Betreiben eines Energiegewinnungssystems,
wobei ein Solargenerator (3), insbesondere aus einem oder mehreren Solarzellen umfassenden Modulen, mit einem Wechselrichter (2) an dessen gleichstromseitigem Anschluss verbunden ist,
und der Wechselrichter (2) an seinem wechselspannungsseitigen Anschluss mit einem Verbraucher und/oder einem Wechselstromnetz (1) verbunden ist,
und wobei der Wechselrichter (2) einen Maximum Power Point (MPP)-Tracker aufweist, **dadurch gekennzeichnet, dass** aus einem Energiespeicher (4) über einen Stromrichter, **also DC/DC-Wandler,** elektrische Energie dem Wechselrichter (2) zugeführt wird
und die am Wechselrichter (2) gleichstromseitig anliegende Spannung erfasst wird und eine vom Stromrichter an den gleichstromseitigen Anschluss des Wechselrichters (2) zu liefernde Soll-Leistung gemäß einer Kennlinie, **welche die Abhängigkeit der von dem DC/DC-Wandler zur Verfügung zu stellenden Leistung zur gleichstromseitig am Wechselrichter (2) anliegende Spannung darstellt,** bestimmt wird,
**wobei die vom Stromrichter an den gleichstromseitigen Anschluss des Wechselrichters (2) gelieferte Ist-Leistung bestimmt wird, insbesondere indem die gleichstromseitig anliegende Spannung mit dem vom Stromrichter an den Wechselrichter (2) gelieferten Strom multipliziert wird, und aus der Differenz zwischen Soll-Leistung und Ist-Leistung der vom Stromrichter an den Wechselrichter (2) zu liefernde Strom bestimmt wird, insbesondere wobei weitere Einflussgrößen, wie Betriebsart (22), Verhalten (21) des MPP-Trackers des Wechselrichters (2) oder dergleichen, berücksichtigt werden,**
**wobei die Kennlinie entsprechend von Einflussgrößen verändert wird, insbesondere gedehnt oder gestaucht wird, insbesondere in Ordinatenrichtung,**
**wobei die Kennlinie einen derartigen Zusammenhang zwischen der vom DC/DC-Wandler zur Verfügung zu stellenden Leistung und gleichstromseitiger Spannung darstellt, dass nach Addition einer entsprechenden Leistungs-Spannungs-Kennlinie des Solargenerators (3) derjenige Wert der Spannung, bei dem ein Maximum an Leistung vorliegt, unverändert bleibt,**
**wobei die Kennlinie derart veränderlich ist, dass nach Addition einer entsprechenden Leistungs-Spannungs-Kennlinie des Solargenerators (3) derjenige Wert der Spannung, bei dem ein Maximum an vom DC/DC-Wandler zur Verfügung zu stellender Leistung vorliegt, unverändert bleibt, insbesondere so dass der MPP-Tracker auf dasselbe Leistungsmaximum des Solargenerators (3) hinregelt, wie wenn kein Energiespeicher (4) mit Stromrichter vorhanden wäre,**
**wobei zur Leistungsabgabe des Speichers ohne vorhandene PV-Leistung, insbesondere also nachts, statt der Kennlinie eine zweite Kennlinie verwendet wird, welche einen derartigen Zusammenhang zwischen der vom DC/DC-Wandler zur Verfügung zu stellenden Leistung und gleichstromseitigen Spannung darstellt, dass sie ein ausgeprägtes Maximum bei** einer **Spannung U_S aufweist, welche sich nach dem Arbeitspunkt der höchsten Effizienz des Gesamtsystems richtet.**

2. Verfahren nach Anspruch 1,
**dadurch gekennzeichnet, dass**
die Kennlinie ein Maximum in demjenigen Spannungsbereich aufweist, aus denjenigen Spannungswerten gebildet ist, die jeweils zu einem Arbeitspunkt mit maximaler Leistung des Solargenerators (3) in Abhängigkeit von der Spannung gehören, wobei hierbei alle Betriebsbedingungen, insbesondere Temperatur und Beleuchtungsstärke berücksichtigt werden.

3. Verfahren nach mindestens einem der vorangegangenen Ansprüche, **dadurch gekennzeichnet, dass**
das Vorzeichen der Kennlinie, **also das Vorzeichen der vom DC/DC-Wandler zur Verfügung zu stellenden Leistung,** abhängig von der Betriebsart (22), insbesondere Entnahme von Energie aus dem oder Zuführung von Energie in den Energiespeicher (4).

4. Verfahren nach mindestens einem der vorangegangenen Ansprüche, **dadurch gekennzeichnet, dass**
die Kennlinie einen konstanten Soll-Leistungs-Wert aufweist in einem Spannungs-Bereich, welcher denjenigen jeweiligen Spannungswert umfasst, welcher dem Leistungsmaximum des Solargenerators (3) zugeordnet ist, insbesondere welcher dem Leistungsmaximum des Solargenerators (3) zugeordnet ist bei allen Betriebsbedingungen, insbesondere zulässigen Temperaturen und/oder Beleuchtungsstärken, des Solargenerators (3).

5. Verfahren nach mindestens einem der vorangegangenen Ansprüche, **dadurch gekennzeichnet, dass**
die Kennlinie einen lokal minimalen Verlauf der Soll-Leistungs-Werte in Abhängigkeit von der Spannung aufweist in einem Spannungs-Bereich, welcher denjenigen jeweiligen Spannungswert umfasst, welcher dem Leistungsmaximum des Solargenerators (3) zugeordnet ist, insbesondere welcher dem Leistungsmaximum des Solargenerators (3) zugeordnet ist bei allen Beleuchtungsstärken des Solargenerators (3).

## Claims

1. Method for operating an energy production system,
wherein a solar generator (3), especially made of modules comprising one or more solar cells, is connected to an inverter (2) at the DC-side terminal thereof,
and the inverter (2) is connected at its terminal on the AC-voltage side to a power consumer and/or an AC system (1),
and wherein the inverter (2) has a maximum power point (MPP) tracker,
**characterised in that**
electrical energy is supplied to the inverter (2) from an energy store (4) via a power converter, that is DC/DC converter,
and the voltage present at the inverter (2) on the DC side is detected, and a setpoint power to be delivered by the power converter to the DC-side terminal of the inverter (2) is determined according to a characteristic curve which represents the dependence of the power to be made available by the DC/DC converter with respect to the voltage present at the inverter (2) on the DC side,
wherein the actual power delivered by the power converter to the DC-side terminal of the inverter (2) is determined, especially by multiplying the voltage present on the DC side by the current delivered by the power converter to the inverter (2), and based on the difference between the setpoint power and the actual power of the current to be delivered by the power converter to the inverter (2), especially wherein further influence variables, such as operating mode (22), behaviour (21) of the MPP tracker of the inverter (2) or the like are taken into account,
wherein the characteristic curve is altered accordingly by influence variables, especially expanded or compressed, especially in the ordinate direction,
wherein the characteristic curve represents a correlation of such a kind between the power to be made available by the DC/DC converter and DC-side voltage that after addition of a corresponding power-voltage characteristic curve of the solar generator (3), the value of the voltage at which a maximum of power is present remains unchanged,
wherein the characteristic curve is changeable so that after addition of a corresponding power-voltage characteristic curve of the solar generator (3), the value of the voltage at which a maximum of power to be made available by the DC/DC converter is present remains unchanged, especially so that the MPP tracker regulates to the same power maximum of the solar generator (3) as if no energy store (4) with power converter were present,
wherein for the power release from the store without PV-power present, that is especially at night, instead of the characteristic curve a second characteristic curve is used, which represents a correlation of such a kind between the power to be made available by the DC/DC converter and voltage on the DC side that it has a distinct maximum at a voltage U_S which is located at the operating point of greatest efficiency of the overall system.

2. Method according to claim 1,
**charact rised in that**
the characteristic curve has a maximum in the voltage range that is formed of those voltage values that in each case belong to an operating point having maximum power of the solar generator (3) as a function of the voltage, all operating conditions, especially temperature and light intensity, being taken into account in this connection.

3. Method according to at least one of the preceding claims, **characterised in that**
the sign of the characteristic curve, that is the sign of the power to be made available by the DC/DC converter, is a function of the operating mode (22), especially drawing of energy from or feeding of energy into the energy store (4).

4. Method according to at least one of the preceding claims, **characterised in that**
the characteristic curve has a constant setpoint-power value in a voltage range which includes the specific voltage value that is assigned to the power maximum of the solar generator (3), especially which is assigned to the power maximum of the solar generator (3) in the case of all operating conditions, especially permissible temperatures and/or light intensities of the solar generator (3).

5. Method according to at least one of the preceding claims, **characterised in that**
the characteristic curve has a locally minimal progression of setpoint-power values as a function of the voltage in a voltage range which includes the specific voltage value that is assigned to the power maximum of the solar generator (3), especially which is assigned to the power maximum of the solar generator (3) in the case of all light intensities of the solar generator (3).

## Revendications

1. Procédé pour faire fonctionner un système de production d'énergie,
dans lequel un générateur solaire (3), en particulier formé d'un ou plusieurs modules comprenant des cellules solaires, est relié à un onduleur (2) à sa borne côté courant continu,
et l'onduleur (2) est relié par sa borne côté courant alternatif à un consommateur et/ou à un réseau à courant alternatif (1),
et dans lequel l'onduleur (2) présente un suiveur de point de puissance maximale (MPP),
**caractérisé en ce que**
de l'énergie électrique est fournie à l'onduleur (2) à partir d'un accumulateur d'énergie (4) par l'intermédiaire d'un convertisseur de courant, à savoir un convertisseur continu-continu,
et la tension présente à l'onduleur (2) côté courant continu est détectée et une puissance de consigne à fournir par le convertisseur de courant à la borne côté courant continu de l'onduleur (2) est déterminée suivant une courbe caractéristique qui représente la dépendance de la puissance à fournir par le convertisseur continu-continu par rapport à la tension présente à l'onduleur (2) côté courant continu,
dans lequel la puissance réelle fournie par le convertisseur de courant à la borne côté courant continu de l'onduleur (2) est déterminée, en particulier en multipliant la tension présente côté courant continu par le courant fourni par le convertisseur de courant à l'onduleur (2), et le courant à fournir par le convertisseur de courant à l'onduleur (2) est déterminé à partir de la différence entre la puissance de consigne et la puissance réelle, en particulier d'autres facteurs d'influence, comme le mode de fonctionnement (22), le comportement (21) du suiveur MPP de l'onduleur (2) ou analogues, sont pris en compte,
dans lequel la courbe caractéristique est modifiée, en particulier étirée ou comprimée, en particulier dans la direction des ordonnées, en fonction de facteurs d'influence,
dans lequel la courbe caractéristique représente une relation telle entre la puissance à fournir par le convertisseur continu-continu et la tension côté courant continu qu'après addition d'une courbe caractéristique puissance-tension correspondante du générateur solaire (3), la valeur de la tension à laquelle un maximum de puissance est présent reste inchangée,
dans lequel la courbe caractéristique est variable de telle sorte qu'après addition d'une courbe caractéristique puissance-tension correspondante du générateur solaire (3), la valeur de la tension à laquelle un maximum de la puissance à fournir par le convertisseur continu-continu est présent reste inchangée, en particulier de sorte que le suiveur MPP effectue une régulation sur le même maximum de puissance du générateur solaire (3) que si aucun accumulateur d'énergie (4) avec convertisseur de courant n'était présent,
dans lequel, pour la puissance de sortie de l'accumulateur en l'absence de puissance PV, donc en particulier la nuit, on utilise à la place de la courbe caractéristique une deuxième courbe caractéristique qui représente une relation telle entre la puissance à fournir par le convertisseur continu-continu et la tension côté courant continu qu'elle présente un maximum marqué à une tension U_S, laquelle est fonction du point de travail d'efficacité maximale du système complet.

2. Procédé selon la revendication 1,
**caractérisé en ce que**
la courbe caractéristique présente un maximum dans la plage de tensions à partir desquelles sont formées des valeurs de tension qui appartiennent chaque fois à un point de travail à puissance maximale du générateur solaire (3) en fonction de la tension, toutes les conditions de fonctionnement, en particulier la température et l'intensité d'éclairement, étant prises en compte.

3. Procédé selon au moins l'une des revendications précédentes,
**caractérisé en ce que**
le signe de la courbe caractéristique, donc le signe de la puissance à fournir par le convertisseur continu-continu, dépend du mode de fonctionnement (22), en particulier prélèvement d'énergie de l'accumulateur d'énergie (4) ou apport d'énergie à l'accumulateur d'énergie (4).

4. Procédé selon au moins l'une des revendications précédentes,
**caractérisé en ce que**
la courbe caractéristique présente une valeur de puissance de consigne constante dans une plage de tensions qui comprend la valeur de tension respective qui est associée au maximum de puissance du générateur solaire (3), en particulier qui est associée au maximum de puissance du générateur solaire (3) dans toutes les conditions de fonctionnement, en particulier les températures et/ou intensités d'éclairement admissibles du générateur solaire (3).

5. Procédé selon au moins l'une des revendications précédentes,
**caractérisé en ce que**
la courbe caractéristique présente une allure minimale locale des valeurs de puissance de consigne en fonction de la tension dans une plage de tensions qui comprend la valeur de tension respective qui est associée au maximum de puissance du générateur solaire (3), en particulier qui est associée au maximum de puissance du générateur solaire (3) à toutes les intensités d'éclairement du générateur solaire (3).
